(19) **Europäisches Patentamt**
**European Patent Office**
**Office européen des brevets**

(11) **EP 2 173 795 B1**

(12) **EUROPEAN PATENT SPECIFICATION**

(45) Date of publication and mention
of the grant of the patent:
**22.11.2017 Bulletin 2017/47**

(51) Int Cl.:
***C08J 7/04*** *(2006.01)*     ***C08J 5/18*** *(2006.01)*
***C08L 67/02*** *(2006.01)*     ***H01L 51/00*** *(2006.01)*

(21) Application number: **08776114.4**

(86) International application number:
**PCT/GB2008/002633**

(22) Date of filing: **01.08.2008**

(87) International publication number:
**WO 2009/016388 (05.02.2009 Gazette 2009/06)**

(54) **COATED POLYESTER FILM**

BESCHICHTETE POLYESTERFOLIE

FILM DE POLYESTER REVÊTU

(84) Designated Contracting States:
**AT BE BG CH CY CZ DE DK EE ES FI FR GB GR HR HU IE IS IT LI LT LU LV MC MT NL NO PL PT RO SE SI SK TR**

(30) Priority: **02.08.2007 GB 0715062**
               **08.08.2007 GB 0715452**
               **16.08.2007 GB 0716017**

(43) Date of publication of application:
**14.04.2010 Bulletin 2010/15**

(73) Proprietor: **DUPONT TEIJIN FILMS U.S. LIMITED PARTNERSHIP**
**Wilmington, Delaware 19805 (US)**

(72) Inventors:
• **MACDONALD, William, A.**
**Guisborough, North Yorkshire (GB)**
• **MACKERRON, Duncan, Henry**
**Stokesley, North Yorkshire TS9 5NX (GB)**
• **EVESON, Robert, W.**
**Cleveland TS15 9UZ (GB)**
• **RAKOS, Karl**
**Darlington DL1 4RQ (GB)**

(74) Representative: **Cockerton, Bruce Roger**
**Carpmaels & Ransford LLP**
**One Southampton Row**
**London WC1B 5HA (GB)**

(56) References cited:
**EP-A- 1 452 309     WO-A-03/022575**

**Description**

The present invention relates to improvements in polyester film to make it more suitable as a flexible substrate in electronic, photonic and optical assemblies or structures, particularly electronic displays, photovoltaic cells and semiconductor devices.

Polyester film is known for use in the manufacture of flexible electronic or optoelectronic technology, as disclosed in, for instance, US2004/0265539 and WO-A-03/022575. The polyester film acts a substrate on which electronic circuitry is manufactured and mounted in order to drive the electronic operation of the flexible device. The component which comprises the flexible substrate and circuitry is often described as a backplane. The polyester film substrate must satisfy a number of requirements, including dimensional stability (particularly at high temperatures); and a high degree of surface smoothness in order that the thin conductive layer(s) disposed thereupon are as defect-free as possible. The presence of defects in the conductive layer reduces the pixel yield in the electronic display, i.e. the number of pixels in the field of view, and therefore reduces the quality of the display. The substrate, which typically has a multi-layer structure, must also exhibit good adhesion between the layers thereof, as well as good adhesion to the conductive layer disposed thereupon. Moreover, a new generation of electronic devices and displays, including rollable electronic displays, has increased the requirements of flexibility for the substrate and the assembly comprising the substrate. In these new electronic devices, it is desired to increase flexibility to the extent that the device is able to conform to a curved or cylindrical surface, and particularly is able to do so reversibly, without adversely affecting the functionality of the device. A rollable electronic display is a display which is sufficiently flexible that it can be rolled from a flat form into a substantially cylindrical form, and particularly that it can be reversibly rolled. In other electronic devices and electronic displays, it is desired to allow bending of the device or display at a specified angle. It is therefore desirable to produce a device or display in which it is possible to induce a specified curvature.

The object of the present invention is to address one or more of the afore-mentioned problems.

The present invention provides a method of improving the flexibility of a coated polyester substrate for an electronic device comprising a coated polyester substrate layer and an electrode layer comprising conductive material, said method comprising:

(a) providing a polyester film; and
(b) disposing an organic/inorganic hybrid coating on one or both surfaces of said polyester film,

wherein said coating is derived from a coating composition comprising a low molecular weight reactive component selected from monomeric acrylates and/or an unsaturated oligomeric component selected from acrylates, polyether acrylates, epoxy acrylates and polyester acrylates; a solvent; and silica particles, and optionally further comprising a photoinitiator and the coating has a dry thickness of from 1 to 20 $\mu$m, wherein the coated polyester substrate has a greater resistance to cracking of the coating upon application of a strain and/or bending force when compared to a polyester substrate coated with an alternative coating composition.

By improving (i.e. increasing) the flexibility of the polyester substrate, the flexibility of the electronic device or electronic display is thereby improved, allowing the manufacture of, for instance, rollable electronic displays and devices.

The present invention further provides a method of improving the flexibility of an electronic device comprising a coated polyester substrate layer and an electrode layer comprising conductive material, said method comprising:

(a) selecting the polyester substrate to be a polyester film coated on one or both surfaces thereof with an organic/inorganic hybrid coating which is derived from a coating composition comprising a low molecular weight reactive component selected from monomeric acrylates and/or an unsaturated oligomeric component selected from acrylates, polyether acrylates, epoxy acrylates and polyester acrylates; a solvent; and silica particles, and optionally further comprising a photoinitiator, and the coating has a dry thickness of from 1 to 20 $\mu$m; and
(b) providing said film as a substrate in the electronic device, wherein the electronic device has a greater resistance to cracking of the electrode layer upon application of a strain and/or bending force when compared with an electronic device including a polyester substrate coating with an alternative coating composition.

In one embodiment, the organic/inorganic hybrid coating is present on both sides of the polyester substrate.

The term "improved flexibility" is used herein to refer to a polyester substrate coated with a coating composition as defined herein, which has a greater resistance to cracking of the coating of the coated substrate upon application of a strain and/or a bending force, when compared to a substrate coated with an alternative coating composition.

In particular, the coating compositions as defined herein improve flexibility to the extent that the polyester substrate coated with a coating composition as defined herein can be elongated in the transverse direction at a draw rate of 60mm/min by about 3% or more, preferably about 5% or more, preferably about 8% or more, preferably about 10% or more, preferably about 12% or more, preferably about 15% or more, preferably about 20% or more, preferably about 25% or more of its original dimension before a first crack appears in the coating of the coated polyester substrate.

The term "improved flexibility" is also used herein to refer to a polyester substrate coated with a coating composition and electrode layer as defined herein or to an electronic device comprising the coated polyester substrate and electrode layer as defined herein, which has a greater resistance to cracking of the electrode layer upon application of a strain and/or a bending force, when compared to a substrate coated with an alternative composition or an electronic device including a polyester substrate coated with an alternative coating composition.

In particular, the coating compositions as defined herein improve flexibility to the extent that the polyester substrate coated with a coating composition and electrode layer as defined herein can be elongated in the transverse direction at a draw rate of 60mm/min by about 3% or more, preferably about 5% or more, preferably about 8% or more, preferably about 10% or more, preferably about 12% or more, preferably about 15% or more of its original dimension before a first crack appears in the conductive material of the electrode layer.

This improvement in flexibility is particularly advantageous where the substrate layer is to be used in the manufacture of an electronic device which is rollable i. e. a device which can be rolled from a flat form into a substantially cylindrical form.

The "critical radius of curvature" of the polyester substrate coated with a coating composition provides a measure of the degree to which the coated polyester substrate may be deformed whilst retaining mechanical integrity, *i.e.* before a first crack appears in the coated substrate. Thus, the "critical radius of curvature" is the minimum radius to which the coating of the coated polyester substrate can be bent before a first crack appears in the coating of the coated substrate.

Similarly, when referring to the "critical radius of curvature" of the polyester substrate coated with a coating composition and electrode layer, it is the minimum radius to which the coated polyester substrate can be bent before a first crack appears in the conductive material of the electrode layer.

In particular, the improvement in flexibility is such that the polyester substrate coated with a coating composition, has a critical radius of curvature of about 10 mm or less, preferably about 8 mm or less, preferably about 6 mm or less, preferably about 5 mm or less, preferably about 4 mm or less, preferably about 3 mm or less, preferably about 2.5 mm or less, preferably about 2 mm or less, preferably about 1.5 mm or less, preferably about 1 mm or less, preferably about 0.75 mm or less, preferably about 0.5 mm or less.

For the polyester substrate coated with a coating composition and electrode layer, the improvement in flexibility is such that the polyester substrate coated with a coating composition and electrode layer, has a critical radius of curvature of about 10 mm or less, preferably about 8 mm or less, preferably about 6 mm or less, preferably about 5 mm or less, preferably about 4 mm or less, preferably about 3 mm or less, preferably about 2.5 mm or less, preferably about 2 mm or less, preferably about 1.5 mm or less.

The term polyester as used herein includes a polyester homopolymer in its simplest form or modified, chemically and/or physically. In particular, the film substrate is a biaxially oriented polymeric film comprising a layer of polyester or copolyester derived from:

   (i) one or more diol(s);
   (ii) one or more aromatic dicarboxylic acid(s); and
   (iii) optionally, one or more aliphatic dicarboxylic acid(s) of the general formula $C_nH_{2n}(COOH)_2$ wherein n is 2 to 8,

wherein the aromatic dicarboxylic acid is present in the (co)polyester in an amount of from about 80 to about 100 mole % based on the total amount of dicarboxylic acid components in the (co)polyester. A copolyester may be a random, alternating or block copolyester.

The thickness of the biaxially oriented polyester film is preferably from about 12 to about 250 $\mu$m, more preferably from about 12 to about 150 $\mu$m, and typically is about 25-125 $\mu$m in thickness. The film is self-supporting by which is meant capable of independent existence in the absence of a supporting base.

The polyester is obtainable by condensing said dicarboxylic acids or their lower alkyl (up to 6 carbon atoms) diesters with one or more diols. The aromatic dicarboxylic acid is preferably selected from terephthalic acid, isophathalic acid, phthalic acid, 2,5-, 2,6- or 2,7-naphthalenedicarboxylic acid, and is preferably terephthalic acid or 2,6-naphthalenedicarboxylic acid, preferably 2,6-naphthalenedicarboxylic acid. The diol is preferably selected from aliphatic and cycloaliphatic glycols, e.g. ethylene glycol, 1,3-propanediol, 1,4-butanediol, neopentyl glycol and 1,4-cyclohexanedimethanol, preferably from aliphatic glycols. Preferably the copolyester contains only one glycol, preferably ethylene glycol. The aliphatic dicarboxylic acid may be succinic acid, glutaric acid, adipic acid, pimelic acid, suberic acid, azeleic acid or sebacic acid. Preferred homopolyesters are polyesters of 2,6-naphthalenedicarboxylic acid or terephthalic acid with ethylene glycol. A particularly preferred homopolyester is poly(ethylene naphthalate), and particularly polyesters of 2,6-naphthalenedicarboxylic acid with ethylene glycol.

Formation of the polyester is conveniently effected in a known manner by condensation or ester interchange, generally at temperatures up to about 295°C. For instance, the preferred PEN polyester can be synthesised by condensing 2,5-, 2,6- or 2,7-naphthalenedicarboxylic acid, preferably 2,6-naphthalenedicarboxylic acid, or a lower alkyl (up to 6 carbon atoms) diester thereof, with ethylene glycol. Typically, polycondensation includes a solid phase polymerisation stage. The solid phase polymerisation may be carried out on a fluidised bed, e.g. fluidised with nitrogen, or on a vacuum fluidised bed, using a rotary vacuum drier. Suitable solid phase polymerisation techniques are disclosed in, for example, EP-A-0419400 the disclosure of which is incorporated herein by reference. In one embodiment, the PEN is prepared using germanium catalysts which provide a polymeric material having a reduced level of contaminants such as catalyst residues, undesirable inorganic deposits and other byproducts of the polymer manufacture. The "cleaner" polymeric composition promotes improved optical clarity and surface smoothness. Preferably, PEN has a PET-equivalent intrinsic viscosity (IV) of 0.5-1.5, preferably 0.7-1.5, and in particular 0.79-1.0. An IV of less than 0.5 results in a polymeric film lacking desired properties such as mechanical properties whereas an IV of greater than 1.5 is difficult to achieve and would likely lead to processing difficulties of the raw material.

Formation of the film may be effected by conventional techniques well-known in the art. Conveniently, formation of the film is effected by extrusion, in accordance with the procedure described below. In general terms the process comprises the steps of extruding a layer of molten polymer, quenching the extrudate and orienting the quenched extrudate in at least one direction.

The film may be biaxially-oriented. Preferably, the film is biaxially oriented. Orientation may be effected by any process known in the art for producing an oriented film, for example a tubular or flat film process. Biaxial orientation is effected by drawing in two mutually perpendicular directions in the plane of the film to achieve a satisfactory combination of mechanical and physical properties.

In a tubular process, simultaneous biaxial orientation may be effected by extruding a thermoplastics polyester tube which is subsequently quenched, reheated and then expanded by internal gas pressure to induce transverse orientation, and withdrawn at a rate which will induce longitudinal orientation.

In the preferred flat film process, the film-forming polyester is extruded through a slot die and rapidly quenched upon a chilled casting drum to ensure that the polyester is quenched to the amorphous state. Orientation is then effected by stretching the quenched extrudate in at least one direction at a temperature above the glass transition temperature of the polyester. Sequential orientation may be effected by stretching a flat, quenched extrudate firstly in one direction, usually the longitudinal direction, i.e. the forward direction through the film stretching machine, and then in the transverse direction. Forward stretching of the extrudate is conveniently effected over a set of rotating rolls or between two pairs of nip rolls, transverse stretching then being effected in a stenter apparatus. Stretching is generally effected so that the dimension of the oriented film is from 2 to 5, more preferably 2.5 to 4.5 times its original dimension in the or each direction of stretching. Typically, stretching is effected at temperatures higher than the Tg of the polyester, preferably about 15°C higher than the Tg. Greater draw ratios (for example, up to about 8 times) may be used if orientation in only one direction is required. It is not necessary to stretch equally in the machine and transverse directions although this is preferred if balanced properties are desired.

A stretched film may be, and preferably is, dimensionally stabilised by heat-setting under dimensional support at a temperature above the glass transition temperature of the polyester but below the melting temperature thereof, to induce crystallisation of the polyester. During the heat-setting, a small amount of dimensional relaxation may be performed in the transverse direction, TD by a procedure known as "toe-in". Toe-in can involve dimensional shrinkage of the order 2 to 4% but an analogous dimensional relaxation in the process or machine direction, MD is difficult to achieve since low line tensions are required and film control and winding becomes problematic. The actual heat-set temperature and time will vary depending on the composition of the film and its desired final thermal shrinkage but should not be selected so as to substantially degrade the toughness properties of the film such as tear resistance. Within these constraints, a heat set temperature of about 180° to 245°C is generally desirable.

The film may also, and indeed preferably is, further stabilized through use of an online relaxation stage. Alternatively the relaxation treatment can be performed off-line. In this additional step, the film is heated at a temperature lower than that of the heat-setting stage, and with a much reduced MD and TD tension. Film thus processed will exhibit a smaller thermal shrinkage than that produced in the absence of such post heat-setting relaxation.

In one embodiment, heat-setting and heat-stabilisation of the biaxially stretched film is conducted as follows. After the stretching steps have been completed, heat-setting is effected by dimensionally restraining the film at a tension in the range of about 19 to about 75 kg/m, preferably about 45 to about 50 kg/m of film width, using a heat-set temperature preferably from about 135° to about 250°C, more preferably 235-240°C and a heating duration typically in the range of 5 to 40 secs, preferably 8 to 30 secs. The heat-set film is then heat-stabilised by heating it under low tension, preferably such that the tension experienced by the film is less than 5 kg/m, preferably less than 3.5 kg/m, more preferably in the range of from 1 to about 2.5 kg/m, and typically in the range of 1.5 to 2 kg/m of film width, typically using a temperature lower than that used for the heat-setting step and selected to be in the range from about 135°C to 250°C, preferably 190 to 250°C, more preferably 200 to 230°C, and more preferably at least 215°C, typically 215 to 230°C, and for a duration of heating typically in the range of 10 to 40 sec, with a duration of 20 to 30 secs being preferred.

The heat-set, heat-stabilised film exhibits a very low residual shrinkage and consequently high dimensional stability. Preferably, the film exhibits a coefficient of linear thermal expansion (CLTE) within the temperature range from -40 °C to +100 °C of less than $40 \times 10^{-6}/°C$, preferably less than $30 \times 10^{-6}/°C$, more preferably less than $25 \times 10^{-6}/°C$, more preferably less than $20 \times 10^{-6}/°C$. Preferably, the film has a shrinkage at 30 mins at 230°C, measured as defined herein, of less than 1%, preferably less than 0.75%, preferably less than 0.5%, preferably less than 0.25%, and more preferably less than 0.1%. Preferably, the film has a residual dimensional change $\Delta L_r$ measured at 25°C before and after heating the film from 8°C to 200°C and then cooling to 8°C, of less than 0.75%, preferably less than 0.5 %, preferably less than 0.25%, and more preferably less than 0.1%, of the original dimension. In a particularly preferred embodiment, the substrate is a heat-stabilised, heat-set biaxially oriented film comprising poly(ethylene naphthalate) having the afore-mentioned shrinkage characteristics after 30 min at 230°C, and preferably having the afore-mentioned residual dimensional change $\Delta L_r$ characteristics. It will be appreciated that these dimensional stability characteristics refer to the uncoated heat-stabilised, heat-set, biaxially oriented polyester film.

The film may conveniently contain any of the additives conventionally employed in the manufacture of polyester films. Thus, agents such as cross-linking agents, pigments and voiding agents, agents such as anti-oxidants, radical scavengers, UV absorbers, thermal stabilisers, flame retardants and inhibitors, which are solid, or bound covalently to the polyester and finally agents such as optical brighteners, gloss improvers, prodegradents, viscosity modifiers and dispersion stabilisers may be incorporated as appropriate. In particular, the film may comprise a particulate filler which can improve handling and windability during manufacture. The particulate filler may, for example, be a particulate inorganic filler (e.g. voiding or non-voiding metal or metalloid oxides, such as alumina, silica and titania, calcined china clay and alkaline metal salts, such as the carbonates and sulphates of calcium and barium), or an incompatible resin filler (e.g. polyamides and olefin polymers, particularly a homo- or co-polymer of a mono-alpha-olefin containing up to 6 carbon atoms in its molecule) or a mixture of two or more such fillers.

The components of the composition of a layer may be mixed together in a conventional manner. For example, by mixing with the monomeric reactants from which the film-forming polyester is derived, or the components may be mixed with the polyester by tumble or dry blending or by compounding in an extruder, followed by cooling and, usually, comminution into granules or chips. Masterbatching technology may also be employed.

In a preferred embodiment, the film is optically clear, preferably having a % of scattered visible light (haze) of <10%, preferably <6%, more preferably <3.5 % and particularly <1.5%, measured according to the standard ASTM D 1003. In this embodiment, filler is typically present in only small amounts, generally not exceeding 0.5% and preferably less than 0.2% by weight of a given layer.

One or both surfaces of the polyester film has disposed thereon an organic/inorganic hybrid coating derived from a coating composition comprising a low molecular weight reactive component and/or an unsaturated oligomeric component; a solvent; and silica particles, and optionally further comprising a photoinitiator, as referred to hereinabove. The organic/inorganic hybrid coating layer provides a flat, planarised surface to the substrate film whose natural surface roughness may vary as a function of inorganic filler particles present in its composition. The organic/inorganic hybrid coating preferably also provides a degree of mechanical protection to the film, as judged for example by the Taber abraser test (ASTM Method D-1044). The Taber Abrasion test will typically cause controlled damage to the surface of unprotected film such that under the standard conditions of treatment, the haze of the film is seen to increase by 40-50%. The organic/inorganic hybrid coating resists the deterioration of the film surface under similar conditions and results in an increase in measured haze of the material of preferably no more than 20%, more preferably no more than 10% and most preferably no more than 5%.

The organic/inorganic hybrid coatings described herein comprise silica particles distributed throughout an organic polymeric matrix. The polymeric matrix is derived from a coating composition comprising (i) a low molecular weight reactive component (e.g a monomeric acrylate); and/or (ii) an unsaturated oligomeric component (e.g, acrylates, urethane acrylates, polyether acrylates, epoxy acrylates or polyester acrylates); (iii) a solvent, and optionally (iv) a photoinitiator. As used herein, the term "low molecular weight" describes a polymerisable monomeric species. The term "reactive" signifies the polymerisability of the monomeric species. The coatings are cured either thermally or by free radical reaction initiated by a photolytic route, and the presence of a photoinitiator is optional.

The silica particles can be dispersed in the polymerisable organic matrix by a number of strategies. The silica particles preferably have an average particle diameter of 0.005 to 3 $\mu$m; in one embodiment at least 0.01 $\mu$m, and in one embodment no more than 1 $\mu$m. The silica particles do not substantially affect the optical properties of the substrate. In one embodiment, the silica particles are present in an amount of from about 5% to about 60% by weight of the solids components of the coating composition, and preferably from about 5% to about 60% by weight of the cured coating layer.

In one embodiment, the organic/inorganic hybrid coating composition is UV-curable and comprises monomeric acrylates (typically multi-functional acrylates) in combination with inorganic (preferably silica) particles in a solvent (such as methylethylketone), typically wherein the coating composition comprises the acrylates and silica at about 5 to 50 wt% solids of the total weight of the coating composition, and typically further comprising a minor amount (e.g. about 1% by weight of the solids) of photoinitiator. Multi-functional monomeric acrylates are known in the art, and examples include dipentaerythritol tetraacrylate and tris(2-acryloyloxyethyl) iso cyanurate.

Preferably the coating composition comprises at least two different multifunctional monomeric acrylates.

The coating compositions can be applied using conventional coating techniques, including continuous as well as dip coating procedures. The coatings are applied to a dry thickness of from 1 to 20 microns, preferably from about 2 to 10 microns, and particularly from about 3 to about 10 microns. The coating composition can be applied either "off-line" as a process step distinct from the film manufacture, or "in-line" as a continuation of the film manufacturing process. The coating compositions, after application to the substrate, can be cured at a temperature of from about 20 to about 200°C, preferably from about 20 to about 150°C. While ambient temperatures of 20°C require cure times of several days, elevated temperatures of 150°C will cure the coatings in several seconds.

The exposed surface of the film may, if desired, be subjected to a chemical or physical surface-modifying treatment to improve the bond between that surface and a subsequently applied layer. A preferred treatment, because of its simplicity and effectiveness, is to subject the exposed surface of the film to a high voltage electrical stress accompanied by corona discharge. The preferred treatment by corona discharge may be effected in air at atmospheric pressure with conventional equipment using a high frequency, high voltage generator, preferably having a power output of from 1 to 20 kW at a potential of 1 to 100 kV. Discharge is conventionally accomplished by passing the film over a dielectric support roller at the discharge station at a linear speed preferably of 1.0 to 500 m per minute. The discharge electrodes may be positioned 0.1 to 10.0 mm from the moving film surface.

In a preferred embodiment, the polyester film base is coated on one or both surfaces thereof, prior to application of the organic/inorganic hybrid coating, with a primer layer to improve adhesion of the substrate to the afore-mentioned coating composition. The primer layer may be any suitable adhesion-promoting polymeric composition known in the art, including polyester and acrylic resins. The primer composition may also be a mixture of a polyester resin with an acrylic resin. Acrylic resins may optionally comprise oxazoline groups and polyalkylene oxide chains. The polymer(s) of the primer composition is/are preferably water-soluble or water-dispersible.

Polyester primer components include those obtained from the following dicarboxylic acids and diols. Suitable di-acids include terephthalic acid, isophthalic acid, phthalic acid, phthalic anhydride, 2,6-naphthalenedicarboxylic acid, 1,4-cyclohexanedicarboxylic acid, adipic acid, sebacic acid, trimellitic acid, pyromellitic acid, a dimer acid, and 5-sodium sulfoisophthalic acid. A copolyester using two or more dicarboxylic acid components is preferred. The polyester may optionally contain a minor amount of an unsaturated di-acid component such as maleic acid or itaconic acid or a small amount of a hydroxycarboxylic acid component such as *p*-hydroxybenzoic acid. Suitable diols include ethylene glycol, 1,4-butanediol, diethylene glycol, dipropylene glycol, 1,6-hexanediol, 1,4-cyclohexanedimethylol, xylene glycol, dimethylolpropane, poly(ethylene oxide) glycol, and poly(tetramethylene oxide) glycol. The glass transition point of the polyester is preferably 40 to 100 °C, further preferably 60 to 80 °C. Suitable polyesters include copolyesters of PET or PEN with relatively minor amounts of one or more other dicarboxylic acid comonomers, particularly aromatic di-acids such as isophthalic acid and sodium sulphoisophthalic acid, and optionally relatively minor amounts of one or more glycols other than ethylene glycol, such as diethylene glycol.

In one embodiment, the primer layer comprises an acrylate or methacrylate polymer resin. The acrylic resin may comprise one or more other comonomers. Suitable comonomers include alkyl acrylates, alkyl methacrylates (where the alkyl group is preferably methyl, ethyl, *n*-propyl, isopropyl, *n*-butyl, isobutyl, *t*-butyl, 2-ethylhexyl, cyclohexyl or the like); hydroxy-containing monomers such as 2-hydroxyethyl acrylate, 2-hydroxyethyl methacrylate, 2-hydroxypropyl acrylate, and 2-hydroxypropyl methacrylate; epoxy group-containing monomers such as glycidyl acrylate, glycidyl methacrylate, and allyl glycidyl ether; carboxyl group or its salt-containing monomers, such as acrylic acid, methacrylic acid, itaconic acid, maleic acid, fumaric acid, crotonic acid, styrenesulfonic acid and their salts (sodium salt, potassium salt, ammonium salt, quaternary amine salt or the like); amide group-containing monomers such as acrylamide, methacrylamide, an N-alkylacrylamide, an N-alkylmethacrylamide, an N,N-dialkylacrylamide, an N,N-dialkyl methacrylate (where the alkyl group is preferably selected from those described above), an N-alkoxyacrylamide, an N-alkoxymethacrylamide, an N,N-dialkoxyacrylamide, an N,N-dialkoxymethacrylamide (the alkoxy group is preferably methoxy, ethoxy, butoxy, isobutoxy or the like), acryloylmorpholine, N-methylolacrylamide, N-methylolmethacrylamide, N-phenylacrylamide, and N-phenylmethacrylamide; acid anhydrides such as maleic anhydride and itaconic anhydride; vinyl isocyanate, allyl isocyanate, styrene, $\alpha$-methylstyrene, vinyl methyl ether, vinyl ethyl ether, a vinyltrialkoxysilane, a monoalkyl maleate, a monoalkyl fumarate, a monoalkyl itaconate, acrylonitrile, methacrylonitrile, vinylidene chloride, ethylene, propylene, vinyl chloride, vinyl acetate, and butadiene. In a preferred embodiment, the acrylic resin is copolymerised with one or more monomer(s) containing oxazoline groups and polyalkylene oxide chains. The oxazoline group-containing monomer includes 2-vinyl-2-oxazoline, 2-vinyl-4-methyl-2-oxazoline, 2-vinyl-5-methyl-2-oxazoline, 2-isopropenyl-2-oxazoline, 2-isopropenyl-4-methyl-2-oxazoline, and 2-isopropenyl-5-methyl-2-oxazoline. One or more comonomers may be used. 2-Isopropenyl-2-oxazoline is preferred. The polyalkylene oxide chain-containing monomer includes a monomer obtained by adding a polyalkylene oxide to the ester portion of acrylic acid or methacrylic acid. The polyalkylene oxide chain includes polymethylene oxide, polyethylene oxide, polypropylene oxide, and polybutylene oxide. It is preferable that the repeating units of the polyalkylene oxide chain are 3 to 100. Where the primer composition comprises a mixture of polyester and acrylic components, particularly an acrylic resin comprising oxazoline groups and polyalkylene oxide chains, it is preferable that the content of the polyester is 5 to 95 % by weight, preferably 50 to 90 % by weight, and the content of the acrylic resin is 5 to 90 % by weight, preferably 10 to 50 % by weight.

Other suitable acrylic resins include:

(i) a copolymer of (a) 35 to 40 mole % alkyl acrylate, (b) 35 to 40 % alkyl methacrylate, (c) 10 to 15 mole % of a comonomer containing a free carboxyl group such as itaconic acid, and (d) 15 to 20 mole % of an aromatic sulphonic acid and/or salt thereof such as p-styrene sulphonic acid, an example of which is a copolymer comprising ethyl acrylate/methyl methacrylate/itaconic acid/p-styrene sulphonic acid and/or a salt thereof in a ratio of 37.5/37.5/10/15 mole %, as disclosed in EP-A-0429179 the disclosure of which is incorporated herein by reference; and

(ii) an acrylic and/or methacrylic polymeric resin, an example of which is a polymer comprising about 35 to 60 mole % ethyl acrylate, about 30 to 55 mole % methyl methacrylate and about 2 to 20 mole % methacrylamide, as disclosed in EP-A-0408197 the disclosure of which is incorporated herein by reference.

The primer or adherent layer may also comprise a cross-linking agent which improves adhesion to the substrate and should also be capable of internal cross-linking. Suitable cross-linking agents include optionally alkoxylated condensation products of melamine with formaldehyde. The primer or adherent layer may also comprise a cross-linking catalyst, such as ammonium sulphate, to facilitate the cross-linking of the cross-linking agent. Other suitable cross-linking agents and catalysts are disclosed in EP-A-0429179, the disclosures of which are incorporated herein by reference.

A further suitable primer is disclosed in US-3,443,950, the disclosure of which is incorporated herein by reference.

The coating of the primer layer onto the substrate may be performed in-line or off-line, but is preferably performed "in-line", and preferably between the forward and sideways stretches of a biaxial stretching operation.

The coated films preferably have a % of scattered visible light (haze) of <10%, preferably <6%, more preferably <3.5 % and particularly <1.5%, measured according to the standard ASTM D 1003.

In one embodiment of the present invention, the coated films exhibit a surface having an Ra value, measured as described herein, of less than 0.7 nm, preferably less than 0.6 nm, preferably less than 0.5 nm, preferably less than 0.4 nm, preferably less than 0.3 nm, and ideally less than 0.25 nm, and/or an Rq value, measured as described herein, of less than 0.9 nm, preferably less than 0.8 nm, preferably less than 0.75 nm, preferably less than 0.65 nm, preferably less than 0.6 nm, preferably less than 0.50 nm, preferably 0.45nm or lower, preferably less than 0.35 nm, and ideally less than 0.3 nm.

The coated polyester film is suitable as a substrate for, and in the manufacture of, flexible electronic devices, including electronic, photonic and optical assemblies or structures, preferably electronic display devices, photovoltaic cells, sensors and semiconductor devices, particularly in the manufacture of the backplanes referred to above, and more particularly in rollable electronic displays. In one embodiment, the term "electronic device" as used herein refers to a device which contains as essential features at least a polyester substrate and electronic circuitry. Electronic and optoelectronic devices may comprise a conductive polymer. Preferably, the device is an electronic display device including, for example, an electroluminescent (EL) device (particularly an organic light emitting display (OLED)); a photovoltaic cell or a semiconductor device (such as organic field effect transistors, thin film transistors and integrated circuits generally). In one embodiment, the term "electroluminescent display device", and particularly the term "organic light emitting display (OLED) device", as used herein refers to a display device comprising a layer of light-emitting electroluminescent material (particularly a conductive polymeric material) disposed between two layers each of which comprises an electrode, wherein the resultant composite structure is disposed between two substrate (or support or cover) layers. In one embodiment, the term "photovoltaic cell" as used herein refers to a device comprising a layer of conductive polymeric material disposed between two layers each of which comprises an electrode, wherein the resultant composite structure is disposed between two substrate (or support or cover) layers. In one embodiment, the term "transistor" as used herein refers to a device comprising at least one layer of conductive polymer, a gate electrode, a source electrode and a drain electrode, and one or more substrate layers. Thus, in one embodiment, the method and use referred to hereinabove include the step of disposing an electrode layer on the coated substrate described hereinabove, in accordance with conventional manufacturing techniques known in the art, and the composite film referred to hereinabove further comprises an electrode layer (optionally transparent or translucent) on the coated substrate. The electrode layer may have a thickness in the range from about 5 to about 200 mm, preferably about 10 to about 100nm, preferably from about 15 to about 50 nm and particularly from about 20 to about 30 nm. The electrode layer may be a layer, or a patterned layer, of a suitable conductive material as known in the art, for instance gold or a conductive metal oxide such as indium tin oxide, optionally doped with other metals as is known in the art. Other materials suitable as for the electrode layer are well-known to the skilled person and include, for instance, silver, aluminium platinum, palladium, nickel. In a preferred embodiment, the electrode layer comprises gold. In one embodiment, a tie layer is deposited on the coated film referred to hereinabove prior to deposition of the electrode layer. Such a tie-layer typically comprises a metallic layer deposited by conventional techniques onto a surface of the coated film, wherein the metallic layer is different to the conductive material of the electrode layer. For instance, where the electrode layer is gold, the tie layer may be a layer of metallic titanium.

In a further embodiment, the composite film described hereinabove may further comprise a layer which exhibits barrier properties to water vapour and/or oxygen transmission, particularly such that the water vapour transmission rate is less than $10^{-6}g/m^2/day$ and/or the oxygen transmission rate is less than $10^{-5}/mL/m^2/day$, and which is typically applied prior to application of the electrode layer. Such a barrier layer may be organic or inorganic (preferably inorganic), and is typically applied by vacuum deposition or sputtering techniques. Materials which are suitable for use to form a barrier layer are disclosed, for instance, in US-6,198,217 and WO-A-03/087247.

According to a further aspect of the present invention, there is provided a method of manufacture of a rollable electronic display as defined in claim 12.

## Figures

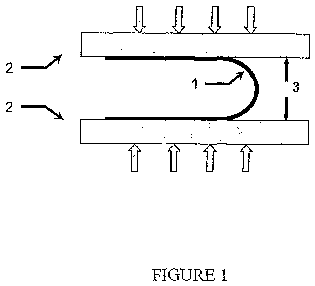

Figure 1 is an illustration of the two point bending test, described in further detail below.

As shown in Figure 1, in the two point bending test, a specimen for evaluation (1) is deformed between two parallel platens (2). The platens (2) are separated by a distance (3) which, when the deformation of the specimen is approximated to the arc of a circle, is taken to be 2 x critical radius of curvature.

## Property Measurement

The following analyses were used to characterize the films described herein:

(i) Thermal shrinkage was assessed for film samples of dimensions 200mm x 10 mm which were cut in specific directions relative to the machine and transverse directions of the film and marked for visual measurement. The longer dimension of the sample (i.e. the 200mm dimension) corresponds to the film direction for which shrinkage is being tested, i.e. for the assessment of shrinkage in the machine direction, the 200 mm dimension of the test sample is oriented along the machine direction of the film. After heating the specimen to the predetermined temperature (by placing in a heated oven at that temperature) and holding for an interval of 30 minutes, it was cooled to room temperature and its dimensions re-measured manually. The thermal shrinkage was calculated and expressed as a percentage of the original length.

(ii) For film samples which were essentially transparent, that is containing sufficiently low levels of additive, pigment, void or other body which would render it opaque, film clarity was evaluated. This was achieved by measuring total luminance transmission (TLT) and haze (% of scattered transmitted visible light) through the total thickness of the film using a Gardner XL 211 hazemeter in accordance with ASTM D-1003-61.

(iii) Dimensional stability may be assessed in terms of either (a) the coefficient of linear thermal expansion (CLTE) or (b) a temperature cycling method wherein the residual change in length along a given axis is measured after heating the film to a given temperature and subsequently cooling the film.

Both methods of measurements were conducted using a Thermomechanical Analyser PE-TMA-7 (Perkin Elmer) calibrated and checked in accordance with known procedures for temperature, displacement, force, eigendeformation, baseline and furnace temperature alignment. The films were examined using extension analysis clamps. The baseline required for the extension clamps was obtained using a very low coefficient of expansion specimen (quartz) and the CLTE precision and accuracy (dependent on post-scan baseline subtraction) was assessed using a standard material, e.g. pure aluminium foil, for which the CLTE value is well known. The specimens, selected from known axes of orientation within the original film samples, were mounted in the system using a clamp separation of approx.12mm and subjected to an applied force of 75mN over a 5mm width. The applied force was adjusted for changes in film thickness, i.e. to ensure consistent tension, and the film was not curved along the axis of analysis. Specimen lengths were normalised to the length measured at a temperature of 23°C.

In the CLTE test method (a), specimens were cooled to 8°C, stabilised, then heated at 5°C/min from 8°C to +240°C. The CLTE values ($\alpha$) were derived from the formula:

$$\alpha = \Delta L / (L \times (T_2 - T_1))$$

where $\Delta L$ is the measured change in length of the specimen over the temperature range ($T_2 - T_1$), and L is the original specimen length at 23°C. CLTE values are considered reliable up to the temperature of the Tg.

The data can be plotted as a function of the % change in specimen length with temperature, normalised to 23°C.

In the temperature cycling test method (b), a procedure similar to that of method (a) was used wherein the temperature was cycled between 8°C and several elevated temperatures. Thus, film samples were heated from 8°C to 140°C, 160°C, 180°C or 200°C and then cooled to 8°C. The length along each of the transverse and machine directions was measured at 25°C before and after this heat treatment and the change in length $\Delta L_r$ calculated as percentage of the original length.

(iv) Intrinsic Viscosity (IV)

The IV was measured by melt viscometry, using the following procedure. The rate of flow pre-dried extrudate through a calibrated die at known temperature and pressure is measured by a transducer which is linked to a computer. The computer programme calculates melt viscosity values ($\log_{10}$ viscosity) and equivalent IVs from a regression equation determined experimentally. A plot of the IV against time in minutes is made by the computer and the degradation rate is calculated. An extrapolation of the graph to zero time gives the initial IV and equivalent melt viscosity. The die orifice diameter is 0.020 inches, with a melt temperature of 284°C for IV up to 0.80, and 295°C for IV>0.80.

(v) Oxygen transmission rate is measured using ASTM D3985.

(vi) Water vapour transmission rate is measured using ASTM F1249.

(vii) Surface Smoothness

Surface smoothness is measured using conventional non-contacting, white-light, phase-shifting interferometry techniques, which are well-known in the art, using a Wyko NT3300 surface profiler using a light source of wavelength 604nm. With reference to the WYKO Surface Profiler Technical Reference Manual (Veeco Process Metrology, Arizona, US; June 1998; the disclosure of which is incorporated herein by reference), the characterising data obtainable using the technique include:

> *Averaging Parameter - **Roughness Average** (**Ra**) : the arithmetic average of the absolute values of the measured height deviations within the evaluation area and measured from the mean surface.*
> *Averaging Parameter - Root Mean Square Roughness (Rq) : the root mean square average of the measured height deviations within the evaluation area and measured from the mean surface.*
> *Extreme Value Parameter - Maximum Profile Peak Height (Rp) : the height of the highest peak in the evaluation area, as measured from the mean surface.*
> *Averaged Extreme Value Parameter - Average Maximum Profile Peak Height (Rpm) : the arithmetic average value of the ten highest peaks in the evaluation area.*
> *Extreme Peak Height Distribution : a number distribution of the values of Rp of height greater than 200nm.*
> *Surface Area Index : a measure of the relative flatness of a surface.*

The roughness parameters and peak heights are measured relative to the average level of the sample surface area, or "mean surface", in accordance with conventional techniques. (A polymeric film surface may not be perfectly flat, and often has gentle undulations across its surface. The mean surface is a plane that runs centrally through undulations and surface height departures, dividing the profile such that there are equal volumes above and below the mean surface.)

The surface profile analysis is conducted by scanning discrete regions of the film surface within the "field of view" of the surface profiler instrument, which is the area scanned in a single measurement. A film sample may be analysed using a discrete field of view, or by scanning successive fields of view to form an array. The analyses conducted herein utilised the full resolution of the Wyko NT3300 surface profiler, in which each field of view comprises 480 x 736 pixels.

For the measurement of Ra and Rq, the resolution was enhanced using an objective lens having a 50-times magnification. The resultant field of view has dimensions of 90 $\mu$m x 120 $\mu$m, with a pixel size of 0.163 $\mu$m.

For the measurement of Rp and Rpm, the field of view is conveniently increased using an objective lens having a 10-times magnification in combination with a "0.5-times field of view of multiplier" to give a total magnification of 5-times. The resultant field of view has dimensions of 0.9 mm x 1.2 mm, with a pixel size of 1.63 $\mu$m. Preferably Rp is less than 100nm, more preferably less than 60nm, more preferably less than 50nm, more preferably less than 40nm, more preferably less than 30nm, and more preferably less than 20nm.

For the measurement of Ra and Rq herein, the results of five successive scans over the same portion of the surface area are combined to give an average value. The data presented below in respect of Rp are an average value from 100 measurements. The measurements were conducted using a modulation threshold (signal: noise ratio) of 10%, i.e. data points below the threshold are identified as bad data.

The surface topography can also be analysed for the presence of extreme peaks having a height of greater than 200nm. In this analysis, a series of measurements of Rp are taken with a pixel size of 1.63 $\mu$m over a total

area of 5cm$^2$. The results may be presented in the form of a histogram in which the data-points are assigned to pre-determined ranges of peak heights, for instance wherein the histogram has equally-spaced channels along the x-axis of channel width 25nm. The histogram may be presented in the form of a graph of peak count (y axis) versus peak height (x axis). The number of surface peaks in the range 300 to 600 nm per 5cm$^2$ area, as determined from Rp values, may be calculated, and designated as N(300-600). The coatings used in the present invention preferably result in a reduction of N(300-600) in the annealed film, such that the reduction F, which is the ratio of N(300-600) without and with the coating, is at least 5, preferably at least 15, and more preferably at least 30. Preferably, the N(300-600) value of the coated and subsequently annealed film is less than 50, preferably less than 35, preferably less than 20, preferably less than 10, and preferably less than 5 peaks per 5cm$^2$ area.

The Surface Area Index is calculated from the "3-dimensional surface area" and the "lateral surface area" as follows. The "3-dimensional (3-D) surface area" of a sample area is the total exposed 3-D surface area including peaks and valleys. The "lateral surface area" is the surface area measured in the lateral direction. To calculate the 3-D surface area, four pixels with surface height are used to generate a pixel located in the centre with X, Y and Z dimensions. The four resultant triangular areas are then used to generate approximate cubic volume. This four-pixel window moves through the entire data-set. The lateral surface area is calculated by multiplying the number of pixels in the field of view by the XY size of each pixel. The surface area index is calculated by dividing the 3-D surface area by the lateral area, and is a measure of the relative flatness of a surface. An index which is very close to unity describes a very flat surface where the lateral (XY) area is very near the total 3-D area (XYZ).

A Peak-to-Valley value, referred to herein as "$PV_{95}$", may be obtained from the frequency distribution of positive and negative surface heights as a function of surface height referenced to the mean surface plane. The value $PV_{95}$ is the peak-to-valley height difference which envelops 95% of the peak-to-valley surface height data in the distribution curve by omitting the highest and lowest 2.5% of datapoints. The $PV_{95}$ parameter provides a statistically significant measure of the overall peak-to-valley spread of surface heights.

(viii) Fracture under Tension

Samples of the film are cut into strips which are 100mm long (machine direction (MD)) by 10mm wide (transverse direction (TD)). Using an Instron machine the samples are elongated in the machine direction by a user-defined percentage (% strain) of their original dimensions at a draw rate of 60mm/min. The starting length between clamps is 80mm. The resulting samples are then inspected for cracks in the coating by reflective microscopy (in the case of the planarised films) and differential interference contrast microscopy (in the case of the conductive-coated planarised films, i.e. the exemplified gold-coated films) using a Leica DM RX microscope. The number of cracks within a 1 cm by 1 cm area is counted under a magnification of 2.5. A crack which covers at least half of the 1 cm length in the TD is counted in the case of a partial crack. From this procedure, a critical strain can be determined, which is defined as the maximum strain exhibited before the appearance of the first crack in the coating layer being analysed (i.e. the coating which is uppermost in the composite film when the surface of the composite film is analysed as described immediately above).

(ix) Fracture under Bending

For flexible electronic devices, the typical form of deformation experienced by the laminate stack is "bending". The thickness of the stack can be imagined to be subdivided into very thin lamellae, each extending over the whole area of the sample. The lamellae increase in length along the arc produced by bending if they lie towards the outer surface, and decrease in length if they lie towards the inner surface. The strain of each lamella is taken as positive for an increase in length, and is defined as the increase in length divided by the original length. Likewise, the strain is taken as negative for a decrease in length and defined as the decrease in length divided by the original length. Therefore bending produces a positive strain in the direction of the arc for lamellae near the outer surface, and a negative strain for lamellae near the inner surface, with a continuous, linear variation between the two surfaces. It will be recognised that although this section (ix), and the following analysis, defines strain as a simple fraction, the parameter may also be expressed as a percentage fraction. (The percentage strain is of course simply obtained by multiplying the fractional strain by 100%). In this specification the context will make it clear which definition is being used. In section (viii) and the examples the strain is described or reported as a percentage quantity.

The shape of the bent laminate stack for a small length at one location along the direction of bending approximates a portion of a cylinder, whose radius is termed the "radius of curvature". At any instant in an experimental test, the radius of curvature may vary with location along the whole length of the sample, and has a smallest value termed the "minimum radius of curvature" at some particular location. Correspondingly, the strains will vary with location along the length as well as through the thickness. As the test proceeds, the minimum radius of curvature becomes smaller, and the magnitude of the strains at that location will become larger. The laminate stack will fail in the test when the minimum radius falls below a certain value, termed the "critical radius of curvature". If the mechanism of failure is by cracking, the critical radius of curvature is defined as the smallest radius of curvature measured before the appearance of the first crack. The radius of curvature reaching its critical value corresponds to the strain in one of the layers reaching the critical strain in tension determined in (viii) above. Normally, the layer that fails is located adjacent to the outer surface of the bent sample, and is therefore subject to the largest positive or tensile strain. Elasticity theory may be used to form a mathematical relationship between the radius of curvature and strain in the outer layer, and hence between their critical values.

A well-established test for plate-like materials is the 2-point bending test as illustrated in figure 1, in which a specimen is deformed between two parallel platens. In a typical, approximate analysis of the test, the deformation of the specimen between the platens is assumed to be a circular arc and the separation between the platens taken to be 2 x radius of curvature, ("Preparation and Characterization of Graphene oxide Paper", D. A. Dikin et. al., Nature 448, 457 (2007)).

However such experimental approaches to measuring the critical radius of curvature are in practice difficult to carry out, often leading to unreliable results. For example, the film may slip on the platens as it is deformed and it has proved difficult to monitor crack initiation in this non-planar geometry. In addition, a more accurate analysis shows that the deformed film deviates significantly from the shape of a circular arc. In the present invention, it has proved more convenient to calculate the critical radius of curvature of the sample from the observed critical strain in tension.

The calculation of critical radius of curvature proceeds as follows. The sheet bends into a portion of a cylinder. At each location around the circumference, Cartesian axes are defined with the x-axis lying at a tangent to the circumferential (bending) direction. There is no curvature parallel to the axis of the cylinder, whose direction defines axis $y$. (This is true over nearly all the sample dimension in this direction, except for negligibly small parts near the edges, which are ignored in the analysis). The z-axis is perpendicular to the sheet, with z = 0 on the inner surface. The components of strain in an imaginary thin lamella located a distance z from the inner surface are taken as:

$$\varepsilon_x = (z - T/2)/R + \varepsilon_x^0 \quad ; \quad \varepsilon_y = \varepsilon_y^0 \tag{1}$$

The components of strain are $\varepsilon_x$ in the direction of bending, and $\varepsilon_y$ in the direction perpendicular to both the bending direction and the thickness. The total thickness is $T$, and the lamella at the middle surface $z=T/2$ is bent to a radius of *curvature R.* Additional strains $\varepsilon_x^0$, $\varepsilon_y^0$ are imposed uniformly through the thickness: their magnitudes are determined later from the requirement to maintain the condition of zero average stress. These expressions are valid for the practical case of the radius of curvature $R$ much larger than the stack thickness $T$. Each layer, with index $i$, is assumed to be strain-free in the laminate stack before bending, linearly elastic and isotropic, with Young's modulus $E_i$ and Poisson's ratio $v_i$. During bending, each lamella develops stress with components in the $x$ and $y$ directions, $\sigma_x$, $\sigma_y$ respectively. The stress component is the internal force acting in a particular direction in the lamella, divided by the cross-section area perpendicular to that direction. According to small-strain elasticity theory, stresses and strains are related for each lamella in material layer $i$ by:

$$\varepsilon_x = 1/E_i(\sigma_x - v_i\sigma_y) \quad ; \quad \varepsilon_y = 1/E_i(\sigma_y - v_i\sigma_x) \tag{2}$$

Solving equations 1 and 2 for stress $\sigma$ at a position z in layer number i gives:

$$\sigma_x = C_i((z - T/2)/R + \varepsilon_x^0 + v_i\varepsilon_y^0)$$

$$\sigma_y = C_i(\varepsilon_y^0 + v_i(z - T/2)/R + v_i\varepsilon_x^0) \tag{3}$$

where $C_i = E_i/(1 - v_i^2)$ In most bending tests, the laminate is not subjected to any tension or compression forces at the ends or edges. Therefore, the average of each stress component through the thickness is zero. The average is given by summing the values of the stress component for all lamellae through the thickness. This is equivalent to the mathematical integral of equation 3 over values of $z$ between zero and the laminate thickness $T$, i. e.:

$$\int_0^T \sigma_x \, dz = 0, \quad \int_0^T \sigma_y \, dz = 0 \qquad\qquad (4)$$

The contribution of each layer in the stack to the integral can be evaluated using standard methods of calculus, and then all contributions summed. This results in two simultaneous linear equations relating the additional strains $\varepsilon_x^0$, $\varepsilon_y^0$ and the radius of curvature $R$, with the coefficients given by sums that involve the material parameter $C_i$, thickness and distance from the inner surface of each layer. These can be solved, again using standard methods.

The values of $\varepsilon_x^0$, $\varepsilon_y^0$ are then substituted into equation 1 to give an expression for the strain in the bending direction $\varepsilon_x$ at any position z through the thickness. When the value $z=T$ is chosen, a relationship between the radius of curvature and the maximum strain (on the outer surface) is obtained. By choosing a maximum strain value equal to the critical strain for fracture in tension (as measured in (viii) above), the critical radius of curvature can be calculated.

The calculations outlined above are straightforward, but involve many terms once the stack exceeds two layers. Therefore they are best carried out by computer, and in particular an Excel® worksheet has been developed to accept user input of the layer properties, thicknesses and radius of curvature, and calculate the strains according to the procedure above. Details of this worksheet have been disclosed previously. ("Mechanical Integrity of Flexible Displays"; Dilwyn P. Jones, Duncan H MacKerron, & William A MacDonald; "Materials for Displays" Meeting, Institute of Physics, London 2004).

The invention is further illustrated by the following examples. The examples are not intended to limit the invention as described above. Modification of detail may be made without departing from the scope of the invention.

## Examples

### Comparative Example 1

A commercially available biaxially oriented heat-stabilised polyethylene terephthalate (PET) film (Melinex® ST506,; Dupont Teijin Films; UK) having a thickness of 175$\mu$m and treated on both surfaces with an inter-draw in-line primer coating of an acrylic resin as described hereinabove, was used as the substrate. This film was then coated with the inorganic hardcoat disclosed in WO-A-03/087247, prepared before application by the following steps:

(i) 517 cm$^3$ of methyltrimethoxysilane (obtained from OSi Specialities) was added to 1034 cm3 demineralised water at room temperature and stirred for 24 hours.

(ii) 54 cm$^3$ of 3-glycidoxypropyl trimethoxysilane (obtained from Aldrich Chemical Company) was added to 108 cm$^3$ of demineralised water at room temperature and stirred for 24 hours.

(iii) 53 cm$^3$ of 10 % aqueous acetic acid (Aldrich Chemical Company) was added to 700cm$^3$ of Ludox LS colloidal silica (12 nm). To this was added 162 cm$^3$ of the hydrolysed 3-glycidoxypropyl trimethoxysilane/water mixture and 1551cm$^3$ of the hydrolysed methyltrimethoxysilane/water mixture. This mixture was stirred for 12 hours before coating. The final pH of the composition was 6.05.

The coating was applied to both surfaces of the polyester film and crosslinked thermally. The final dry coating thickness, after curing/drying, was 2$\mu$m.

### Comparative Example 2

Comparative example 1 was repeated using an organic coating composition comprising a mixture of monomeric and polymeric acrylates (including methylmethacrylate and ethylacrylate) and a photoinitiator (Irgacure™ 2959; Ciba) in a solvent of methyl ethyl ketone (2-butanone) was prepared at 26.5 wt % solids (of which about 1% of these solids is the photoinitiator) to a viscosity of about 1.22 cP (centipoise). The coating was dried at 80°C and then cured by UV-radiation. The coating did not include any inorganic particles.

Example 1

Comparative example 1 was repeated using a hybrid organic/inorganic coating composition comprising acrylate monomers and silica particles in MEK solvent was prepared to 10% solids and a viscosity of about 1.7 cP. The coating was applied and then cured immediately by UV-radiation.

For each of the three films prepared as described above, a conductive coating comprising a first layer of titanium metal ($0.075\mu$m) and a second layer of gold metal ($0.02\mu$m) was vacuum-coated using conventional sputtering techniques (Ti sputtered at 7kW; Au at 6.5kW). Each film was then analysed using the fracture under tension test described herein. Eight samples were cut from each of the three planarised films and each of the three Au-coated planarised films, in the machine direction. They were then subjected to various levels of strain ranging from 0.5% to 17%. The data are presented in Table 1 below.

**Table 1**

| % Strain | Comp. Ex.1 | | Comp. Ex. 2 | | Example 1 | |
|---|---|---|---|---|---|---|
| | No.cracks in Planarised film | No. cracks in Au-coated film | No.cracks in Planarised film | No. cracks in Au-coated film | No.cracks in Planarised film | No. cracks in Au-coated film |
| 0,5 | - | 0 | - | - | - | - |
| 1 | 0 | 17 | - | - | - | - |
| 2 | - | - | 0 | 0 | - | - |
| 3 | 39 | 200 | 150 | 5 | 0 | 0 |
| 4 | 54 | 250 | 197 | 25 | 0 | 0 |
| 5 | 200 | 300 | 163 | 85 | 0 | 0 |
| 6 | - | - | 184 | 117 | 0 | 1 |
| 7 | - | - | 181 | 71 | 0 | 69 |
| 8 | - | - | 136 | 120 | 0 | 68 |
| 9 | - | - | 140 | 187 | 0 | 90 |
| 16 | - | - | - | - | 0 | - |
| 17 | - | - | - | - | 1 | - |

The data in Table 1 above demonstrate that Example 1 showed surprisingly superior performance.

The critical radius of curvature for each of the above film samples in a two point bend was then calculated from the crack density data using the modelling method described hereinabove. In order to derive these, firstly the critical strain for each sample must be defined. The critical strain, $\varepsilon_c$ is taken here to be the highest observed value of strain at which mechanical integrity is preserved (i.e. the highest strain for which no cracking is observed). These values are listed in table 2 together with corresponding values of stress derived for the particular layer where cracking was observed (i.e. either the polymeric coating layer or the gold layer). The critical stress for the respective layers was calculated using the entries for strain and values for Young's modulus of each of the materials which exhibited fracture as defined in table 3.

**Table 2**

| Laminate | Critical Strain, $\varepsilon_c$ (%) | Critical Stress, $\sigma_c$ (MPa) |
|---|---|---|
| Comparative Ex 1 Planarised Film | 1.0 | 600 |
| Comparative Ex 1 Planarised, Gold coated Film | 0.5 | 390 |
| Comparative Ex 2 Planarised Film | 2.0 | 800 |
| Comparative Ex 2 Planarised, Gold coated Film | 2.0 | 1560 |
| Example 1 Planarised Film | 16 | 6400 |
| Example 1 Planarised, Gold coated Film | 5 | 3900 |

Values for the Young's modulus and Poisson ratio of each material are listed in table 3. These data were required in the subsequent calculation of the critical radius of curvature for each of the multilayer laminate example and comparative examples. In some cases an estimate of the material modulus was adopted, however it was established by further calculation that a tenfold variation in the value of the planariser modulus causes only around 10% variation in the predicted stress in curvature of the corresponding coating.

**Table 3**

|  | Base Film | C.Ex.1 coating | C.Ex.2 coating | Ex.1 coating | Titanium Layer | Gold Layer |
|---|---|---|---|---|---|---|
| Youngs Modulus (GPa) |  | 160 | approx. 40 | approx. 40 | 116 | 78 |
| Poissons Ratio | 0.3 | 0.3 | 0.3 | 0.3 | 0.32 | 0.44 |

The critical radius of curvature (in mm) for each sample calculated in the model described herein is given in Table 4 below. The critical radii are reported below in respect of the coated film and also in respect of the coated film with the Ti/Au layer disposed thereon.

**Table 4**

| Critical radius of Curvature (mm) | Comp.Ex.1 | Comp.Ex.2 | Example 1 |
|---|---|---|---|
| Coated film | 10.18 | 5.34 | 0.72 |
| Coated film+ Ti/Au layer | 22.38 | 5.96 | 2.41 |

The results in Table 3 show that the coated film of Example 1 is unexpectedly more flexible since it can bend to a radius of 0.72mm before the first crack appears. When coated with conductive material, Example 1 can bend to a radius of 2.41mm before the first crack appears, again unexpectedly more flexible than the other examples.

Comparative Examples 3 and 4 and Example 2

The three coating compositions exemplified above were also applied to a biaxially-oriented heat-stabilised PEN substrate having a thickness of 125 μm and treated on both surfaces with an inter-draw in-line primer coating of a sulphonated polyester resin as described hereinabove. The PEN substrate was prepared as follows. A polymer composition comprising PEN was extruded and cast onto a hot rotating polished drum. The film was then fed to a forward draw unit where it was stretched over a series of temperature-controlled rollers in the direction of extrusion (machine direction; MD) to approximately 3.3 times its original dimensions. The draw temperature was approximately 130°C. At this stage, the film was treated on both surfaces with a sulphonated polyester resin primer coating in order to promote adhesion to the subsequent coating. The film was then passed into a stenter oven at a temperature of 135°C where the film was stretched in the sideways direction to approximately 3.4 times its original dimensions. The biaxially stretched film was then heat-set at temperatures up to 235°C by conventional means, while the transverse dimensions of the web were reduced by 4%. The film was then cooled and would onto reels. The total thickness was 125 μm. The heat-set biaxially stretched film was then unwound and then further heat-stabilised in a roll-to-roll process by passing the film through an additional set of ovens, of which the maximum temperature was 190°C. The film was unsupported at its edges and transported through the ovens under a low line tension, allowing it to relax and stabilize further. The biaxially stretched, heat-set, surface-primed and off-line-stabilized film was then unwound and further modified on both sides by the above coatings. The coated films were then sputtered and analysed in the same manner as the PET sample. Similar results were observed.

**Claims**

1. A method of improving the flexibility of a coated polyester substrate for an electronic device comprising a coated polyester substrate layer and an electrode layer comprising a conductive material, said method comprising:

   (a) providing a polyester film; and
   (b) disposing an organic/inorganic hybrid coating on one or both surfaces of said polyester film,

   wherein said coating is derived from a coating composition comprising a low molecular weight reactive component selected from monomeric acrylates and/or an unsaturated oligomeric component selected from acrylates, polyether acrylates, epoxy acrylates and polyester acrylates; a solvent; and silica particles, and optionally further comprising a photoinitiator and the coating has a dry thickness of from 1 to 20 μm, wherein the coated polyester substrate has a greater resistance to cracking of the coating upon application of a strain and/or bending force when compared to a polyester substrate coated with an alternative coating composition.

2. A method of improving the flexibility of an electronic device comprising a coated polyester substrate layer and an electrode layer comprising a conductive material, said method comprising:

(a) selecting the polyester substrate to be a polyester film coated on one or both surfaces thereof with an organic/inorganic hybrid coating which is derived from a coating composition comprising a low molecular weight reactive component selected from monomeric acrylates and/or an unsaturated oligomeric component selected from acrylates, polyether acrylates, epoxy acrylates and polyester acrylates; a solvent; and silica particles, and optionally further comprising a photoinitiator, and the coating has a dry thickness of from 1 to 20 μm; and
(b) providing said film as a substrate in the electronic device, wherein the electronic device has a greater resistance to cracking of the electrode layer upon application of a strain and/or bending force, when compared with an electronic device including a polyester substrate coated with an alternative coating composition.

3. A method according to claim 2, further comprising obtaining the coated polyester film by a method comprising:

(a) providing a polyester film; and
(b) disposing an organic/inorganic hybrid coating on one or both surfaces of said polyester film; wherein said coating is derived from a coating composition comprising a low molecular weight reactive component selected from monomeric acrylates and/or an unsaturated oligomeric component selected from acrylates, polyether acrylates, epoxy acrylates and polyester acrylates; a solvent; and silica particles, and optionally further comprising a photoinitiator, and the coating has a dry thickness of from 1 to 20 μm.

4. A method according to claim 1 further comprising the step of disposing an electrode layer comprising conductive material on one or both surfaces of said coated polyester substrate layer.

5. A method according to any preceding claim, wherein the improvement in flexibility is such that the coated polyester substrate layer or the composite structure comprising said coated polyester substrate layer and electrode layer comprising conductive material can be elongated in the transverse direction at a draw rate of 60 mm/min by 3% or more of its original dimension before a first crack appears in the coating of the coated polyester substrate.

6. A method according to any preceding claim, wherein the improvement in flexibility is such that the coated polyester substrate layer or the composite structure comprising said coated polyester substrate layer and electrode layer comprising conductive material has a critical radius of curvature of 10 mm or less, wherein the critical radius of curvature is determined as described in the description.

7. A method according to any preceding claim, wherein the silica particles are included in amount in the range from 5% to 60% by weight of the solids components of the coating composition.

8. A method according to any preceding claim, wherein the electronic device is an electronic display, and/or a rollable electronic display; a photovoltaic cell; a semiconductor device, and/or a transistor; and a sensor.

9. A method of manufacture of a rollable electronic display comprising a coated polyester substrate layer and an electrode layer comprising conductive material, said method comprising:

(a) providing a polyester film; and
(b) disposing a coating on one or both surfaces of said polyester film, **characterised in that** said coating is an organic/inorganic hybrid coating derived from a coating composition comprising a low molecular weight reactive component selected from monomeric acrylates and/or an unsaturated oligomeric component selected from acrylates, polyether acrylates, epoxy acrylates and polyester acrylates; a solvent; and silica particles, and optionally further comprising a photoinitiator, wherein the silica particles are included in an amount in the range from 5% to 60% by weight of the solids component of the coating composition and the coating has a dry thickness of from 1 to 20 μm,
(c) disposing an electrode layer comprising conductive material on one or both surfaces of said coated polyester film;

and further **characterised in that** the composite structure comprising said coated polyester substrate layer and electrode layer can be elongated in the transverse direction at a draw rate of 60 mm/min by 3% or more of its original dimension before a first crack appears in the conductive material of the electrode layer, and/or **in that** the composite structure comprising the coated polyester substrate layer and electrode layer has a critical radius of curvature of 10 mm or less, wherein the critical radius of curvature is determined as described in the description.

10. A method according to any preceding claim wherein said coating composition is UV-curable, and/or wherein said coating is derived from a UV-curable composition comprising monomeric acrylates, silica particles and a photoinitiator.

11. A method according to claim 10, wherein the organic/inorganic hybrid coating composition comprises two different monomeric acrylates.

12. A method according to any preceding claim wherein said polyester is poly(ethylene naphthalate) or poly(ethylene terephthalate) or 2,6-naphthalenedicarboxylic acid.

13. A method according to any preceding claim, wherein the polyester substrate or film is a biaxially oriented polyester film.

14. A method according to claim 13, wherein the polyester substrate or film is a heat-stabilised, heat-set biaxially oriented polyester film.

15. A method according to claim 14, wherein the heat-stabilised, heat-set, biaxially oriented polyester film exhibits one or more of:

> (i) a shrinkage at 30 mins at 230°C of less than 1%;
> (ii) a residual dimensional change $\Delta L_r$ measured at 25°C before and after heating the film from 8°C to 200°C and then cooling to 8°C, of less than 0.75%; and/or
> (iii) a coefficient of linear thermal expansion (CLTE) within the temperature range from -40°C to +100°C of less than $40 \times 10^{-6}/°C$, wherein (i), (ii) and (iii) are determined as described in the description.

**Patentansprüche**

1. Verfahren zum Verbessern der Flexibilität eines beschichteten Polyestersubstrats für eine elektronische Vorrichtung, die eine beschichtete Polyestersubstratschicht und eine ein leitfähiges Material umfassende Elektrodenschicht umfasst, wobei das Verfahren umfasst:

> (a) Bereitstellen eines Polyesterfilms; und
> (b) Aufbringen einer organisch/anorganischen Hybridbeschichtung auf eine oder beide Oberflächen des Polyesterfilms,

wobei die Beschichtung aus einer Beschichtungszusammensetzung abgeleitet ist, die eine reaktionsfähige Komponente mit niedrigem Molekulargewicht ausgewählt aus monomeren Acrylaten und/oder eine ungesättigte oligomere Komponente ausgewählt aus Acrylaten, Polyetheracrylaten, Epoxyacrylaten und Polyesteracrylaten; ein Lösungsmittel; und Silicapartikel umfasst und gegebenenfalls ferner einen Photoinitiator umfasst, und die Beschichtung eine Trockendicke von 1 bis 20 μm aufweist, wobei das beschichtete Polyestersubstrat bei Anwendung einer Dehn- und/oder Biegekraft eine höhere Rissbeständigkeit der Beschichtung als ein Polyestersubstrat, das mit einer alternativen Beschichtungszusammensetzung beschichtet ist, aufweist.

2. Verfahren zum Verbessern der Flexibilität einer elektronischen Vorrichtung, die eine beschichtete Polyestersubstratschicht und eine ein leitfähiges Material umfassende Elektrodenschicht umfasst, wobei das Verfahren umfasst:

> (a) Auswählen des Polyestersubstrats als Polyesterfilm, der auf einer oder beiden seiner Oberflächen mit einer organisch/anorganischen Hybridbeschichtung beschichtet ist, die aus einer Beschichtungszusammensetzung abgeleitet ist, die eine reaktionsfähige Komponente mit niedrigem Molekulargewicht ausgewählt aus monomeren Acrylaten und/oder eine ungesättigte oligomere Komponente ausgewählt aus Acrylaten, Polyetheracrylaten, Epoxyacrylaten und Polyesteracrylaten; ein Lösungsmittel; und Silicapartikel umfasst und gegebenenfalls ferner einen Photoinitiator umfasst, und wobei die Beschichtung eine Trockendicke von 1 bis 20 μm aufweist; und

(b) Bereitstellen des Films als Substrat in der elektronischen Vorrichtung, wobei die elektronische Vorrichtung bei Anwendung einer Dehn- und/oder Biegekraft eine höhere Rissbeständigkeit der Elektrodenschicht als eine elektronische Vorrichtung, die ein mit einer alternativen Beschichtungszusammensetzung beschichtetes Polyestersubstrat enthält, aufweist.

3. Verfahren gemäß Anspruch 2, ferner umfassend Erhalten des beschichteten Polyesterfilms durch ein Verfahren umfassend:

(a) Bereitstellen eines Polyesterfilms; und
(b) Aufbringen einer organisch/anorganischen Hybridbeschichtung auf eine oder beide Oberflächen des Polyesterfilms; wobei die Beschichtung aus einer Beschichtungszusammensetzung abgeleitet ist, die eine reaktionsfähige Komponente mit niedrigem Molekulargewicht ausgewählt aus monomeren Acrylaten und/oder eine ungesättigte oligomere Komponente ausgewählt aus Acrylaten, Polyetheracrylaten, Epoxyacrylaten und Polyesteracrylaten; ein Lösungsmittel; und Silicapartikel umfasst und gegebenenfalls ferner einen Photoinitiator umfasst, und wobei die Beschichtung eine Trockendicke von 1 bis 20 $\mu$m aufweist.

4. Verfahren gemäß Anspruch 1, ferner umfassend den Schritt des Aufbringens einer leitfähiges Material umfassenden Elektrodenschicht auf eine oder beide Oberflächen der beschichteten Polyestersubstratschicht.

5. Verfahren gemäß einem der vorstehenden Ansprüche, wobei die Verbesserung der Flexibilität derart ist, dass die beschichtete Polyestersubstratschicht oder die Verbundstruktur, die die beschichtete Polyestersubstratschicht und die leitfähiges Material umfassende Elektrodenschicht umfasst, in der Querrichtung mit einer Zuggeschwindigkeit von 60 mm/min um 3 % oder mehr ihrer ursprünglichen Abmessung gedehnt werden kann, bevor ein erster Riss in der Beschichtung des beschichteten Polyestersubstrats erscheint.

6. Verfahren gemäß einem der vorstehenden Ansprüche, wobei die Verbesserung der Flexibilität derart ist, dass die beschichtete Polyestersubstratschicht oder die Verbundstruktur, die die beschichtete Polyestersubstratschicht und die leitfähiges Material umfassende Elektrodenschicht umfasst, einen kritischen Krümmungsradius von 10 mm oder weniger aufweist, wobei der kritische Krümmungsradius wie in der Beschreibung beschrieben bestimmt wird.

7. Verfahren gemäß einem der vorstehenden Ansprüche, wobei die Silicapartikel in einer Menge in dem Bereich von 5 Gew.-% bis 60 Gew.-% der Feststoffkomponenten der Beschichtungszusammensetzung enthalten sind.

8. Verfahren gemäß einem der vorstehenden Ansprüche, wobei die elektronische Vorrichtung eine elektronische Anzeige und/oder eine aufrollbare elektronische Anzeige; eine Photovoltaikzelle; eine Halbleitervorrichtung und/oder ein Transistor; oder ein Sensor ist.

9. Verfahren zum Herstellen einer aufrollbaren elektronischen Anzeige, die eine beschichtete Polyestersubstratschicht und eine leitfähiges Material umfassende Elektrodenschicht umfasst, wobei das Verfahren umfasst:

(a) Bereitstellen eines Polyesterfilms; und
(b) Aufbringen einer Beschichtung auf eine oder beide Oberflächen des Polyesterfilms, **dadurch gekennzeichnet, dass** die Beschichtung eine organisch/anorganische Hybridbeschichtung ist, die aus einer Beschichtungszusammensetzung abgeleitet ist, die eine reaktionsfähige Komponente mit niedrigem Molekulargewicht ausgewählt aus monomeren Acrylaten und/oder eine ungesättigte oligomere Komponente ausgewählt aus Acrylaten, Polyetheracrylaten, Epoxyacrylaten und Polyesteracrylaten; ein Lösungsmittel; und Silicapartikel umfasst und gegebenenfalls ferner einen Photoinitiator umfasst, wobei die Silicapartikel in einer Menge in dem Bereich von 5 Gew.-% bis 60 Gew.-% der Feststoffkomponente der Beschichtungszusammensetzung enthalten sind und die Beschichtung eine Trockendicke von 1 bis 20 $\mu$m aufweist,
(c) Aufbringen einer leitfähiges Material umfassenden Elektrodenschicht auf eine oder beide Oberflächen des beschichteten Polyesterfilms;

und ferner **dadurch gekennzeichnet, dass** die Verbundstruktur, die die beschichtete Polyestersubstratschicht und die Elektrodenschicht umfasst, in der Querrichtung mit einer Zuggeschwindigkeit von 60 mm/min um 3 % oder mehr ihrer ursprünglichen Abmessung gedehnt werden kann, bevor ein erster Riss in dem leitfähigen Material der Elektrodenschicht erscheint, und/oder dadurch, dass die Verbundstruktur, die die beschichtete Polyestersubstratschicht und die Elektrodenschicht umfasst, einen kritischen Krümmungsradius von 10 mm oder weniger aufweist, wobei der kritische Krümmungsradius wie in der Beschreibung beschrieben bestimmt wird.

**10.** Verfahren gemäß einem der vorstehenden Ansprüche, wobei die Beschichtungszusammensetzung UV-härtbar ist, und/oder wobei die Beschichtung aus einer UVhärtbaren Zusammensetzung, die monomere Acrylate, Silicapartikel und einen Photoinitiator umfasst, abgeleitet ist.

**11.** Verfahren gemäß Anspruch 10, wobei die organisch/anorganische Hybridbeschichtungszusammensetzung zwei verschiedene monomere Acrylate umfasst.

**12.** Verfahren gemäß einem der vorstehenden Ansprüche, wobei der Polyester Poly(ethylennaphthalat) oder Poly(ethylenterephthalat) oder 2,6-Naphthalindicarbonsäure ist.

**13.** Verfahren gemäß einem der vorstehenden Ansprüche, wobei das/der Polyestersubstrat oder -film ein biaxial orientierter Polyesterfilm ist.

**14.** Verfahren gemäß Anspruch 13, wobei das/der Polyestersubstrat oder -film ein wärmestabilisierter, wärmegehärteter biaxial orientierter Polyesterfilm ist.

**15.** Verfahren gemäß Anspruch 14, wobei der wärmestabilisierte, wärmegehärtete biaxial orientierte Polyesterfilm eines oder mehrere aufweist von:

> (i) einer Schrumpfung nach 30 min bei 230 °C von weniger als 1 %;
> (ii) einer Restabmessungsveränderung $\Delta L_r$, gemessen bei 25 °C, vor und nach Erhitzen des Films von 8 °C auf 200 °C und dann Abkühlen auf 8 °C von weniger als 0,75 %; und/oder
> (iii) einem linearen Wärmeausdehnungskoeffizienten (CLTE) in dem Temperaturbereich von -40 °C bis +100 °C von weniger als 40 x $10^{-6}$/°C, wobei (i), (ii) und (iii) wie in der Beschreibung beschrieben bestimmt werden.

## Revendications

**1.** Procédé d'amélioration de la flexibilité d'un substrat en polyester revêtu pour un dispositif électronique comprenant une couche de substrat en polyester revêtu et une couche d'électrode comprenant un matériau conducteur, ledit procédé comprenant :

> (a) l'utilisation d'un film de polyester ; et
> (b) la disposition d'un revêtement hybride organique/inorganique sur une surface ou les deux surfaces dudit film de polyester,

dans lequel ledit revêtement est issu d'une composition de revêtement comprenant un constituant réactif de faible masse moléculaire choisi parmi les acrylates monomères et/ou un constituant oligomère insaturé choisi parmi les acrylates, les acrylates de polyéthers, les époxyacrylates et les acrylates de polyesters ; un solvant ; et des particules de silice et comprenant éventuellement en outre un photoinitiateur et le revêtement a une épaisseur à sec de 1 à 20 $\mu$m, dans lequel le substrat en polyester revêtu a une plus grande résistance au craquelage du revêtement lors de l'application d'une contrainte et/ou d'une force de pliage par comparaison avec un substrat en polyester revêtu d'une autre composition de revêtement.

**2.** Procédé d'amélioration de la flexibilité d'un dispositif électronique comprenant une couche de substrat en polyester revêtu et une couche d'électrode comprenant un matériau conducteur, ledit procédé comprenant :

> (a) la sélection du substrat en polyester pour qu'il soit un film de polyester revêtu sur une de ses surfaces ou ses deux surfaces d'un revêtement hybride organique/inorganique qui est issu d'une composition de revêtement comprenant un constituant réactif de faible masse moléculaire choisi parmi les acrylates monomères et/ou un constituant oligomère insaturé choisi parmi les acrylates, les acrylates de polyéthers, les époxyacrylates et les acrylates de polyesters ; un solvant ; et des particules de silice et comprenant éventuellement en outre un photoinitiateur, le revêtement ayant une épaisseur à sec de 1 à 20 $\mu$m ; et
> (b) l'utilisation dudit film en tant que substrat dans le dispositif électronique,

dans lequel le dispositif électronique a une plus grande résistance au craquelage de la couche d'électrode lors de l'application d'une contrainte et/ou d'une force de pliage, par comparaison avec un dispositif électronique comprenant un substrat en polyester revêtu d'une autre composition de revêtement.

3. Procédé selon la revendication 2, comprenant en outre l'obtention du film de polyester revêtu par un procédé comprenant :

(a) l'utilisation d'un film de polyester ; et
(b) la disposition d'un revêtement hybride organique/inorganique sur une surface ou les deux surfaces dudit film de polyester ;

dans lequel ledit revêtement est issu d'une composition de revêtement comprenant un constituant réactif de faible masse moléculaire choisi parmi les acrylates monomères et/ou un constituant oligomère insaturé choisi parmi les acrylates, les acrylates de polyéthers, les époxyacrylates et les acrylates de polyesters ; un solvant ; et des particules de silice et comprenant éventuellement en outre un photoinitiateur et le revêtement a une épaisseur à sec de 1 à 20 $\mu$m.

4. Procédé selon la revendication 1 comprenant en outre l'étape de disposition d'une couche d'électrode comprenant un matériau conducteur sur une surface ou les deux surfaces de ladite couche de substrat en polyester revêtu.

5. Procédé selon une quelconque revendication précédente, dans lequel l'amélioration de flexibilité est telle que la couche de substrat en polyester revêtu ou la structure composite comprenant lesdites couche de substrat en polyester revêtu et couche d'électrode comprenant du matériau conducteur peut être allongée dans la direction transversale à une vitesse d'étirage de 60 mm/min à hauteur de 3 % ou plus de sa dimension d'origine avant qu'une première craquelure apparaisse dans le revêtement du substrat en polyester revêtu.

6. Procédé selon une quelconque revendication précédente, dans lequel l'amélioration de flexibilité est telle que la couche de substrat en polyester revêtu ou la structure composite comprenant lesdites couche de substrat en polyester revêtu et couche d'électrode comprenant du matériau conducteur a un rayon de courbure critique inférieur ou égal à 10 mm, le rayon de courbure critique étant déterminé comme décrit dans la description.

7. Procédé selon une quelconque revendication précédente, dans lequel les particules de silice sont incluses en une quantité dans la plage de 5 % à 60 % en poids des constituants solides de la composition de revêtement.

8. Procédé selon une quelconque revendication précédente, dans lequel le dispositif électronique est un affichage électronique et/ou un affichage électronique enroulable ; une cellule photovoltaïque ; un dispositif à semi-conducteur et/ou un transistor ; ou un capteur.

9. Procédé de fabrication d'un affichage électronique enroulable comprenant une couche de substrat en polyester revêtu et une couche d'électrode comprenant du matériau conducteur, ledit procédé comprenant :

(a) l'utilisation d'un film de polyester ; et
(b) la disposition d'un revêtement sur une surface ou les deux surfaces dudit film de polyester, **caractérisée en ce que** ledit revêtement est un revêtement hybride organique/inorganique issu d'une composition de revêtement comprenant un constituant réactif de faible masse moléculaire choisi parmi les acrylates monomères et/ou un constituant oligomère insaturé choisi parmi les acrylates, les acrylates de polyéthers, les époxyacrylates et les acrylates de polyesters ; un solvant ; et des particules de silice et comprenant éventuellement en outre un photoinitiateur, les particules de silice étant incluses en une quantité dans la plage de 5 % à 60 % en poids des constituants solides de la composition de revêtement et le revêtement ayant une épaisseur à sec de 1 à 20 $\mu$m,
(c) la disposition d'une couche d'électrode comprenant un matériau conducteur sur une surface ou les deux surfaces dudit film de polyester revêtu ;

et **caractérisé en outre en ce que** la structure composite comprenant lesdites couche de substrat en polyester revêtu et couche d'électrode peut être allongée dans la direction transversale à une vitesse d'étirage de 60 mm/min à hauteur de 3 % ou plus de sa dimension d'origine avant qu'une première craquelure apparaisse dans le matériau conducteur de la couche d'électrode et/ou **en ce que** la structure composite comprenant la couche de substrat en polyester revêtu et la couche d'électrode a un rayon de courbure critique inférieur ou égal à 10 mm, le rayon de courbure critique étant déterminé comme décrit dans la description.

**10.** Procédé selon une quelconque revendication précédente dans lequel ladite composition de revêtement est durcissable par UV et/ou dans lequel ledit revêtement est issu d'une composition durcissable par UV comprenant des acrylates monomères, des particules de silice et un photoinitiateur.

**11.** Procédé selon la revendication 10, dans lequel la composition de revêtement hybride organique/inorganique comprend deux acrylates monomères différents.

**12.** Procédé selon une quelconque revendication précédente dans lequel ledit polyester est le poly(naphtalate d'éthylène) ou le poly(téréphtalate d'éthylène) ou l'acide 2,6-naphtalènedicarboxylique.

**13.** Procédé selon une quelconque revendication précédente, dans lequel le substrat ou film en polyester est un film de polyester biorienté.

**14.** Procédé selon la revendication 13, dans lequel le substrat ou film en polyester est un film de polyester biorienté thermodurci et stabilisé à la chaleur.

**15.** Procédé selon la revendication 14, dans lequel le film de polyester biorienté thermodurci et stabilisé à la chaleur présente un ou plusieurs de :

(i) un retrait au bout de 30 min à 230 °C inférieur à 1 % ;
(ii) un changement de dimension résiduel $\Delta L_r$, mesuré à 25 °C avant et après chauffage du film de 8 °C à 200 °C et ensuite refroidissement à 8 °C, inférieur à 0,75 % ; et/ou
(iii) un coefficient de dilatation thermique linéaire (CLTE) sur la plage de température de -40 °C à +100 °C inférieur à $40 \times 10^{-6}/°C$,

(i), (ii) et (iii) étant déterminés comme dans la description.

FIGURE 1

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

### Patent documents cited in the description

- US 20040265539 A
- WO 03022575 A
- EP 0419400 A
- EP 0429179 A
- EP 0408197 A
- US 3443950 A
- US 6198217 B
- WO 03087247 A

### Non-patent literature cited in the description

- **D. A. DIKIN.** Preparation and Characterization of Graphene oxide Paper. *Nature,* 2007, vol. 448, 457
- Mechanical Integrity of Flexible Displays. **DILWYN P. JONES ; DUNCAN H MACKERRON ; WILLIAM A MACDONALD.** Materials for Displays. Institute of Physics, 2004